(19) Europäisches Patentamt
European Patent Office
Office européen des brevets

(11) EP 1 780 812 A2

(12) EUROPEAN PATENT APPLICATION

(43) Date of publication:
02.05.2007 Bulletin 2007/18

(51) Int Cl.:
H01L 39/24 (2006.01)

(21) Application number: 06122166.9

(22) Date of filing: 12.10.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 01.11.2005 JP 2005318722

(71) Applicant: Kabushiki Kaisha Kobe Seiko Sho (Kobe Steel, Ltd.)
Kobe-shi,
Hyogo 651-8585 (JP)

(72) Inventors:
• Miyatake, Takayuki
Kobe-shi
Hyogo 651-2271 (JP)
• Miyazaki, Takayoshi
Kobe-shi
Hyogo 651-2271 (JP)
• Kato, Hiroyuki
Kobe-shi
Hyogo 651-2271 (JP)
• Zaitsu, Kyoji
Kobe-shi
Hyogo 651-2271 (JP)

(74) Representative: TBK-Patent
Bavariaring 4-6
80336 München (DE)

(54) **Internal diffusion process Nb3Sn superconducting wire**

(57) An internal diffusion process $Nb_3Sn$ superconducting wire is produced by drawing a composite wire including a composite material containing a plurality of Nb or Nb based alloy cores embedded in a Cu or Cu based alloy matrix and a Sn or Sn based alloy core disposed in the center portion, a diffusion barrier layer composed of Nb or Ta and disposed on the outer perimeter of the composite material, and stabilizing Cu disposed on the outside of the diffusion barrier layer and heat-treating the resulting composite wire so as to diffuse Sn and react Sn with the Nb or Nb based alloy cores, wherein the area percentage of the stabilizing Cu in a cross section in a direction perpendicular to the axis center of the composite wire is 10% to 35% and the area percentage of the diffusion barrier layer is 10% to 25%.

FIGURE

**Description**

BACKGROUND OF THE INVENTION

1. Field of the Invention

The present invention relates to a $Nb_3Sn$ superconducting wire produced by an internal diffusion process. In particular, it relates to an internal diffusion process $Nb_3Sn$ superconducting wire which exhibits good critical current properties and a large n value in a high magnetic field and which is useful as a raw material of a superconducting magnet for generating a high magnetic field.

2. Description of the Related Art

Among the fields in which the superconducting wires are in the practical use, for a superconducting magnet to be used in a high resolution nuclear magnetic resonance (NMR) analyzer, since the resolution is increased as the generated magnetic field becomes higher, there is an increasing tendency of the magnetic field of the superconducting magnet to become higher in recent years.

A $Nb_3Sn$ wire has become commercially practical as the superconducting wire to be used in a superconducting magnet for generating a high magnetic field. A bronze process has been primarily adopted for manufacturing this $Nb_3Sn$ superconducting wire. This bronze process is a method as described below. A plurality of Nb based core materials are embedded in a Cu-Sn based alloy (bronze) matrix, and the diameters of the above-described Nb based core materials are decreased by drawing so as to produce filaments. A plurality of composite materials of the Nb based core material filaments and bronze are bundled, copper for stabilization (stabilizing Cu) is disposed and, thereafter, drawing is carried out. The above-described composite wire is subjected to a heat treatment (diffusion heat treatment) at about 600˚C or more and 800˚C or less and, thereby, a $Nb_3Sn$ compound layer is formed at the interface between the Nb based filament and the matrix. However, this method has a limitation of the concentration (15.8 percent by mass or less) of Sn soluble in bronze to form a solid solution, and there are problems in that the thickness of the formed $Nb_3Sn$ compound layer is small, the crystallinity is deteriorated and, therefore, the high-magnetic field properties are poor.

Known examples of methods for manufacturing a $Nb_3Sn$ superconducting wire include an internal diffusion process besides the above-described bronze process. As shown in Figure (a schematic sectional view of a composite wire for manufacturing a $Nb_3Sn$ superconducting wire), the internal diffusion process is a method in which a Sn core 2 is embedded in the center portion of a Cu or Cu based alloy matrix 1 (hereafter may be represented by "Cu based alloy matrix") and, in addition, a plurality of Nb cores 3 are disposed in the matrix 1 around the Sn core 2. After drawing is performed, Sn in the Sn core 2 is diffused by a heat treatment, and is reacted with Nb, so that $Nb_3Sn$ is formed (Claims and the like in Japanese Unexamined Patent Application Publication No. 63-213212 and "TEION KOGAKU (Journal of the Cryogenic Society of Japan)" Vol. 39, No. 9, p. 391-398 (2004) "Naibukakusanhou niyoru $Nb_3Sn$ Chodendosenzai no Kaihatsu (Development of $Nb_3Sn$ Superconducting Wire by Internal Diffusion Process)", for example). Furthermore, in the above-described methods, in order to improve the critical current density that is one of the superconducting properties, a method, in which Ti or the like is contained in the Sn core 2 or the Nb core 3 (Sn based alloy core, Nb based alloy core), has been proposed in Claims and the like in Japanese Unexamined Patent Application Publication No. 62-174354, for example.

In the case where a superconducting wire is produced by the above-described internal diffusion process, as shown in Figure, generally, stabilizing Cu 5 is disposed as an outermost layer of the composite material including the matrix 1, the Sn core 2, and the Nb cores and, in addition, a diffusion barrier layer 4 (diffusion prevention layer) for preventing diffusion of Sn into stabilizing Cu is disposed between the stabilizing Cu 5 and the matrix 1, so as to produce a composite wire.

It is shown that since this method has no limitation of the concentration of Sn in contrast to the solid solution limit in the bronze process, the Sn concentration can be set at a maximum, a good $Nb_3Sn$ layer can be formed and, therefore, a superconducting wire exhibiting excellent high-magnetic field properties is produced. In particular, it is known that the $Nb_3Sn$ superconducting wire produced by this method has a critical current density Jc per non-copper portion (= critical current/area other than stabilizing Cu) about three times higher than that of the $Nb_3Sn$ superconducting wire which is produced by the bronze process and which is most frequently used for generation of a magnetic field exceeding 10 T (tesla). Therefore, this wire is frequently applied to nuclear-fusion magnets, accelerator magnets, research magnets, and the like. Furthermore, since the raw materials exhibiting good workability can be used for constituting the composite wire applied to the internal diffusion process, drawing can be performed satisfactorily without conducting intermediate annealing and, therefore, there is also an advantage that production can be performed at a low cost.

A magnet for NMR is operated in a persistent current mode, and is required to exhibit high magnetic field stability. It is important for realization of the high magnetic field stability that a small resistance is generated by the wire itself during the operation in the persistent current mode. As a current is passed through a superconducting wire, a resistance is generated when the current is a specific value (critical current) or more, and a voltage is generated. The relationship between the current I and the voltage V at this time is represented empirically by an approximate expression, such as the following formula (1), and the value of n in this formula (1) is referred to as an "n value":

$$V = V_C (I/I_C)^n \qquad (1)$$

where $I_c$ represents the critical current of the wire and $V_c$ represents a reference voltage for defining $I_c$.

For the superconducting magnet with an operation current $I_{op}$ in the persistent current mode, it is known that a resistance proportionate to $(I_{op}/I_c)^{n-1}$ is generated in the superconducting wire portion.

The above-described n value serves as the amount indicating sharpness of the transition from the super to the normal conductivity. In order to ensure high magnetic field stability, it is required that the n value of the wire is large and, as a matter of course, the critical current is high. Among them, the n value contributes exponentially and, therefore, an increase of the n value exerts a higher effect than an increase of the critical current of the wire. If the n value is small, the operation current of the magnet must be decreased significantly in order to ensure high magnetic field stability. Consequently, the usage of the wire is increased, and the NMR magnet must be upsized, so that the demand for compactness is adversely affected.

When the superconducting wire produced by the internal diffusion process is studied from the view point of the above-described required properties, it is known that the n value is low as compared with the n value of the superconducting wire produced by the bronze process. Under the circumstances, there is a problem in that it is not easy to apply the internal diffusion process $Nb_3Sn$ superconducting wire to the magnet for NMR, which is operated in the persistent current mode and is required to exhibit high magnetic field stability.

SUMMARY OF THE INVENTION

The present invention has been made under the above-described circumstances. Accordingly, it is an object of the present invention to provide an internal diffusion process $Nb_3Sn$ superconducting wire which has an excellent critical current and a large n value, which generates a high magnetic field exceeding 10 T, and which is useful for realizing a compact, low-cost NMR magnet.

In order to achieve the above-described object, an internal diffusion process $Nb_3Sn$ superconducting wire according to an aspect of the present invention is produced by drawing a composite wire including a composite material, a diffusion barrier layer, and stabilizing Cu, the composite material including a plurality of Nb or Nb based alloy cores embedded in a Cu or Cu based alloy matrix and a Sn or Sn based alloy core disposed in the center portion, the diffusion barrier layer being composed of Nb or Ta and disposed on the outer perimeter of the composite material, and the stabilizing Cu being disposed on the outside of the diffusion barrier layer; and heat-treating the resulting composite wire so as to diffuse Sn and react Sn with the Nb or Nb based alloy cores in the composite wire, wherein the area percentage of the stabilizing Cu in a cross section in a direction perpendicular to the axis center of the above-described composite wire is 10% to 35% and the area percentage of the diffusion barrier layer is 10% to 25%.

In the superconducting wire according to an aspect of the present invention, it is preferable that (1) a total of the area percentage of the stabilizing Cu and the area percentage of the diffusion barrier layer is 30% to 40% and/or (2) the area percentage of the Sn or Sn based alloy core in the cross section of the composite wire is 25% to 35%.

According to the present invention, an internal diffusion process $Nb_3Sn$ superconducting wire which has an excellent critical current and a large n value and which generates a high magnetic field exceeding 10 T can be realized by specifying the area percentages of the stabilizing Cu and the diffusion barrier layer within appropriate ranges, and the resulting superconducting wire is useful for realizing a compact, low-cost NMR magnet.

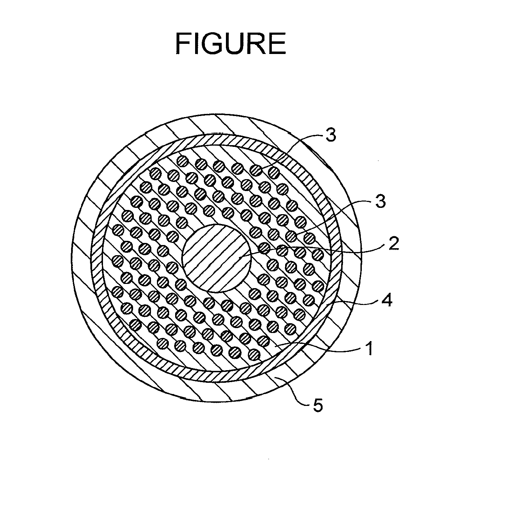

BRIEF DESCRIPTION OF THE DRAWING

Figure is a sectional view schematically showing a composite wire to be applied to an internal diffusion process.

DESCRIPTION OF THE PREFERRED EMBODIMENTS

The distribution of $I_c$ of $Nb_3Sn$ filaments in the wire is believed to be a factor to determine the n value of the superconducting wire. When the difference in $I_c$ is small between the individual $Nb_3Sn$ filaments, the superconductivity

transition width in a current I vs. voltage V curve is decreased (an inclination becomes steep), and a large n value results. Conversely, when the distribution of $I_c$ of the individual $Nb_3Sn$ filaments is wide, the superconductivity transition width is increased (the inclination becomes gentle), and a small n value results.

The distribution of $I_c$ of the $Nb_3Sn$ filaments is believed to occur on the grounds of (a) variations in cross-sectional areas of individual filaments, (b) variations in critical current densities of individual filaments, and the like. The factors of occurrence of the above-described variations shown in the item (b) are believed to be variations in the compositions of $Nb_3Sn$ filaments, the residual strain, and the like, for the $Nb_3Sn$ superconducting wire. Therefore, it is predicted that a large n value can be realized by optimizing these variations.

In the internal diffusion process $Nb_3Sn$ superconducting wire, Sn from the Sn based alloy portion diffuses through the Cu based alloy matrix and a $Nb_3Sn$ phase is formed by a reaction at the interface between the Nb based alloy core and the Cu based alloy matrix at a temperature range on the order of 700°C during the diffusion heat treatment. On the other hand, the superconducting wire is cooled to a liquid helium temperature (about -269°C in general) in use. Consequently, the temperature difference between the time of formation and the time of use is 1000 K.

In these steps, the $Nb_3Sn$ phase is subjected to a large compression stress due to the difference in thermal expansion coefficient between the $Nb_3Sn$ phase and the Cu matrix, and as a result, the compression strain remains in the $Nb_3Sn$ phase. When the strain remains in the $Nb_3Sn$ superconducting wire, the superconducting properties, e.g., the critical temperature $T_c$ and the critical magnetic field $B_{c2}$, are deteriorated significantly, and at the same time, the critical current and the n value are adversely affected.

Considering that a large n value may be realized by reducing the above-described adverse effect, the inventors of the present invention have conducted research on the reduction of the adverse effect from various aspects. Consequently, a concept that it is effective to control the form of wire constituent component responsible for the compression strain on the $Nb_3Sn$ phase has been obtained. Intensive researches on the specific configuration have been further conducted on the basis of the above-described concept. As a result, it has been found that the above-described object has been able to be excellently achieved by appropriately controlling the area percentages (area percentage in a cross section in a direction perpendicular to the axis center) of the stabilizing Cu and the diffusion barrier layer in the composite wire to be applied to the internal diffusion process and, thereby, the present invention has been completed.

According to the research of the inventors of the present invention, it is preferable that the area percentage of the stabilizing Cu in the composite wire is minimized because if the area percentage is increased, the residual strain, which adversely affects the $Nb_3Sn$ phase during the operation of the superconducting wire, is increased. Furthermore, it has been made clear that a larger area percentage of the diffusion barrier layer has derived preferable results of the superconducting properties because the thermal expansion coefficients of Nb and Ta constituting the layer are not significantly different from that of the $Nb_3Sn$ phase. The grounds for limiting the range of the factors specified in the present invention will be described below.

Area percentage of stabilizing Cu: 10% to 35%

If the area percentage of the stabilizing Cu is less than 10%, stable composite fabrication becomes difficult. In particular, breaking or cracking in a billet tends to occur during extrusion or drawing. On the other hand, if the area percentage exceeds 35%, the critical current density $I_c$ and the n value are decreased sharply. In particular, the decrease becomes significant in a high external magnetic field exceeding 18 T. Preferably, the area percentage of the stabilizing Cu is 15% or more, and 25% or less.

For the $Nb_3Sn$ superconducting wire produced by the internal diffusion process, there is a tendency of the Cu area percentage to be maximized in order to avoid burning and the like when quench occurs. For example, it is generally about 60% (1.5 in terms of a Cu ratio = area of a Cu portion/area of a portion other than Cu) for a nuclear fusion magnet (for example, the above-described "TEION KOGAKU (Journal of the Cryogenic Society of Japan)" Vol. 39, No. 9, p. 391-398 (2004)).

Area percentage of diffusion barrier layer: 10% to 25%

If the area percentage of the diffusion barrier layer is less than 10%, since the residual strain is increased, the critical current density $I_c$ and the n value are decreased. In particular, the decrease becomes significant in a high external magnetic field exceeding 18 T. When Nb is used as a material for the diffusion barrier layer, in some cases, a portion, in which the entire diffusion barrier layer is converted to $Nb_3Sn$, may occur during a $Nb_3Sn$ formation heat treatment. If such a situation occurs, Sn enters the stabilizing Cu, which is required to have a low resistance, and the resistance is increased, so that the function as the stabilizing material cannot be exerted. On the other hand, if the area percentage of the diffusion barrier layer exceeds 25%, the drawing of the wire becomes difficult, and in many cases, breaking may result. Preferably, the area percentage of the diffusion barrier layer is 10% or more, and 20% or less.

In general, the diffusion barrier layer has been formed previously in such a way that the thickness is minimized, from the view point of an improvement of the critical current density. The area percentage is usually 3% to 10%. A specific means for forming the diffusion barrier layer around the perimeter of the Cu based alloy matrix may be (1) a method in which the Cu based alloy matrix is inserted into Nb formed to take on the shape of a pipe or a pipe-shaped body formed from Ta. Alternatively, (2) a Nb sheet or a Ta sheet may be wound around the Cu based alloy matrix perimeter.

According to the above-described specification, the total area percentage of the stabilizing Cu and the diffusion barrier layer becomes within the range of 20% to 60%. However, it is preferable that the total area percentage is about 30% to 40% from the view point of the critical current on the entire cross sectional area basis.

Preferably, the area percentage of the "Sn or Sn based alloy core" serving as a Sn supply source is 25% or more from the view point of formation of minimum $Nb_3Sn$ phase, and it is preferable that the area percentage is 35% or less from the view point of prevention of elution of excess Sn.

In the present invention, the above-described composite wire is subjected to drawing and, thereafter, a diffusion heat treatment is performed. In general, the heat treatment temperature is about 650°C or more, and less than 750°C. Each of the above-described area percentages at the stage of the composite wire and at the stage of the superconducting wire after the heat treatment are nearly the same.

In the above-described Figure, a single core (the number of Sn or alloy core is one) is shown as the configuration of the composite wire to be applied to the internal diffusion process. However, as a matter of course, a plurality of single core wires having such a configuration may be disposed in a Cu matrix and, thereby, the present invention may be applied while taking the form of multi-core wire. In the case where the above-described configuration of the multi-core wire is adopted as well, the area percentages of the stabilizing Cu and the diffusion barrier layer in each composite wire must be within the above-described specific range.

In the composite wire of the present invention, a pure Sn core is generally used as this Sn or Sn based alloy core. However, a Sn based alloy core containing 0.1 to 20 percent by mass of Ti or the like may be used for improving the properties. Furthermore, for the Nb core to be used in the composite wire of the present invention, Nb containing 0.1 to 20 percent by mass of Hf, Ta, Ti, Zr, or the like may be used from the similar view point.

The present invention will be described below more specifically with reference to examples. Needless to say, the present invention is not limited by the following examples. As a matter of course, appropriate modifications within the range compatible with the gist described in the present specification can also be added, and these modifications and the like are included within the scope of the present invention.

EXAMPLES

Example 1

A Ti alloy rod containing 1 percent by mass of Nb and having an outer diameter of 58 mm was inserted into a Cu tube having an outer diameter of 65 mm and an inner diameter of 58 mm, and both end portions thereof were sealed by welding, so that extrusion billet was prepared. The resulting billet was subjected to hydrostatic extrusion at 650°C and, thereby, was processed to have an outer diameter of 21 mm. Thereafter, cold dice-drawing was performed so as to produce a wire having a hexagonal cross section (hexagonal single-core wire) with opposite sides of 2 mm.

The resulting hexagonal single-core wire was cut into a predetermined length, followed by bundling, and 306 wires were disposed around a Cu rod having an outer diameter of 70 mm in such a way that the thickness becomes uniform. Furthermore, a Nb sheet or a Ta sheet having a thickness of 0.2 mm was wound around it with a predetermined thickness, so as to produce a diffusion barrier layer. Subsequently, the resulting products were inserted into Cu tubes (stabilizing Cu) having various outer diameters and inner diameters. A gap in the layer, in which the hexagonal single-core wires are bundled, inside the diffusion barrier layer was filled in with Cu spacer, so as to increase the filling factor of the gap between the diffusion barrier layer and the Cu rod.

The outer diameter and the inner diameter of each stabilizing Cu and each diffusion barrier layer when the above-described extrusion billets were configured are shown in the following Table 1 (Sample Nos. 1 to 6).

Table 1

| Sample No. | Stabilizing Cu | | Diffusion barrier layer | | |
|---|---|---|---|---|---|
| | Outer diameter (mm) | Inner diameter (mm) | Material | Outer diameter (mm) | Inner diameter (mm) |
| 1 | 145 | 130 | Nb | 128 | 115 |
| 2 | 145 | 126 | Nb | 124 | 115 |
| 3 | 145 | 121 | Nb | 119 | 115 |

(continued)

| Sample No. | Stabilizing Cu | | Diffusion barrier layer | | |
| --- | --- | --- | --- | --- | --- |
| | Outer diameter (mm) | Inner diameter (mm) | Material | Outer diameter (mm) | Inner diameter (mm) |
| 4 | 145 | 135 | Nb | 133 | 115 |
| 5 | 145 | 139 | Nb | 137 | 115 |
| 6 | 145 | 126 | Ta | 124 | 115 |

A front end portion and a rear end portion of the above-described billet were attached by electron beam welding, so as to further prepare an extrusion billet. The resulting billet was subjected to hydrostatic extrusion at 650°C and, thereby, was processed to have an outer diameter of 39 mm. Thereafter, a hole having a diameter of 16.5 mm was made in the center, and a Sn rod (Sn core) having substantially the same diameter was inserted, so as to produce a composite wire. Each sample of the resulting composite wire was drawn to have a wire diameter of 0.85 mm. However, only Sample No. 1 was processed to have a diameter of 10 mm and, thereafter, divided into 3 sections. One of them was drawn to 0.85 mm as in the above description, another section was inserted into a Cu tube having an outer diameter of 11 mm and an inner diameter of 10 mm, and was drawn to 0.94 mm (Test Nos. 1 and 7). The remaining one section was inserted into a Cu tube having an outer diameter of 12 mm and an inner diameter of 10 mm, and was drawn to 1.03 mm (Test No. 8). Under these conditions, all samples were finished to include a Ti core containing 1 percent by mass of Nb and having an outer diameter of 10 $\mu$m. However, for Sample No. 5, breaking occurred at a stage in which the wire diameter was 3 mm, and the sample was not able to be drawn to the final wire diameter of 0.85 mm (Test No. 5). For every sample, intermediate layer annealing was not carried out during the drawing step.

A part of the resulting samples had large outer diameters (Test Nos. 7 and 8), but the areas of the Nb diffusion barrier layers were equal. The configuration (area percentage of component in wire cross section) of each sample prepared as described above, as well as the wire diameter, the diameter of Ti core containing 1% of Nb, and the diffusion barrier layer material, are shown in the following Table 2.

Table 2

| Test No. | Sample No. | Wire diameter (mm) | Diameter of Ti core containing 1% of Nb ($\mu$m) | Area percentage of component in wire cross section (%) | | | Diffusion barrier layer material | Remarks |
| --- | --- | --- | --- | --- | --- | --- | --- | --- |
| | | | | Stabilizing Cu | Diffusion barrier layer | Others | | |
| 1 | 1 | 0.85 | 10.0 | 20.1 | 15.4 | 64.5 | Nb | - |
| 2 | 2 | 0.85 | 10.0 | 25.1 | 10.5 | 64.4 | Nb | - |
| 3 | 3 | 0.85 | 10.0 | 31.1 | 4.6 | 64.4 | Nb | Sn entered stabilizing Cu |
| 4 | 4 | 0.85 | 10.0 | 13.7 | 21.8 | 64.5 | Nb | - |
| 5 | 5 | - | - | 8.3 | 27.1 | 64.6 | Nb | breaking occurred at 3 mm and predetermined diameter was not reached |
| 6 | 6 | 0.85 | 10.0 | 25.1 | 10.5 | 64.4 | Ta | - |
| 7 | 1 | 0.95 | 10.0 | 34.0 | 12.7 | 53.3 | Nb | Sample No. 1 was inserted into 11-mm Cu tube |

(continued)

| Test No. | Sample No. | Wire diameter (mm) | Diameter of Ti core containing 1% of Nb ($\mu$m) | Area percentage of component in wire cross section (%) | | | Diffusion barrier layer material | Remarks |
| --- | --- | --- | --- | --- | --- | --- | --- | --- |
| | | | | Stabilizing Cu | Diffusion barrier layer | Others | | |
| 8 | 1 | 1.03 | 10.0 | 44.5 | 10.7 | 44.8 | Nb | Sample No. 1 was inserted into 12-mm Cu tube |

About 5 cm of each sample was taken, and was subjected to a $Nb_3Sn$ formation heat treatment at 700°C for 100 hours, so as to produce a $Nb_3Sn$ superconducting wire. The critical current ($I_c$ at a temperature of 4.2 K) and the n value of the resulting $Nb_3Sn$ superconducting wire were measured under the condition in which an external magnetic field of 12 T or 18 T was applied. The results thereof, as well as the area percentage of the component in the wire cross section, are shown in the following Table 3.

Table 3

| Test No. | Area percentage of component in wire cross section (%) | | | Diffusion barrier layer material | Property measurement results | | | | Evaluation |
| --- | --- | --- | --- | --- | --- | --- | --- | --- | --- |
| | Stabilizing Cu | Diffusion barrier layer | Others | | Magnetic field 12 T | | Magnetic field 18 T | | |
| | | | | | Ic (A) | n value | Ic (A) | n value | |
| 1 | 20.1 | 15.4 | 64.5 | Nb | 862 | 52 | 215 | 37 | ○ |
| 2 | 25.1 | 10.5 | 64.4 | Nb | 835 | 48 | 210 | 32 | ○ |
| 3 | 31.1 | 4.6 | 64.4 | Nb | 743 | 40 | 165 | 20 | × |
| 4 | 13.7 | 21.8 | 64.5 | Nb | 984 | 55 | 245 | 41 | ○ |
| 5 | 8.3 | 27.1 | 64.6 | Nb | - | - | - | - | × |
| 6 | 25.1 | 10.5 | 64.4 | Ta | 814 | 50 | 202 | 34 | ○ |
| 7 | 34.0 | 12.7 | 53.3 | Nb | 762 | 38 | 195 | 25 | ○ |
| 8 | 44.5 | 10.7 | 44.8 | Nb | 580 | 25 | 151 | 16 | × |

As is clear from these results, for samples (Test Nos. 1, 2, 4, 6, and 7) which satisfy the factors specified in the present invention, satisfactory critical currents ($I_c$ at a temperature of 4.2 K) and n values are obtained (indicated by "O" in the Evaluation column in Table 3).

An internal diffusion process $Nb_3Sn$ superconducting wire is produced by drawing a composite wire including a composite material containing a plurality of Nb or Nb based alloy cores embedded in a Cu or Cu based alloy matrix and a Sn or Sn based alloy core disposed in the center portion, a diffusion barrier layer composed of Nb or Ta and disposed on the outer perimeter of the composite material, and stabilizing Cu disposed on the outside of the diffusion barrier layer and heat-treating the resulting composite wire so as to diffuse Sn and react Sn with the Nb or Nb based alloy cores, wherein the area percentage of the stabilizing Cu in a cross section in a direction perpendicular to the axis center of the composite wire is 10% to 35% and the area percentage of the diffusion barrier layer is 10% to 25%.

**Claims**

1.  An internal diffusion process $Nb_3Sn$ superconducting wire produced by:

    drawing a composite wire comprising a composite material, a diffusion barrier layer, and stabilizing Cu, the composite material including a plurality of Nb or Nb based alloy cores embedded in a Cu or Cu based alloy matrix and a Sn or Sn based alloy core disposed in the center portion, the diffusion barrier layer being composed of Nb or Ta and disposed on the outer perimeter of the composite material, and the stabilizing Cu being disposed on the outside of the diffusion barrier layer; and

heat-treating the resulting composite wire so as to diffuse Sn and react Sn with the Nb or Nb based alloy cores in the composite wire,

wherein the area percentage of the stabilizing Cu in a cross section in a direction perpendicular to the axis center of the composite wire is 10% to 35% and the area percentage of the diffusion barrier layer is 10% to 25%.

2. The internal diffusion process $Nb_3Sn$ superconducting wire according to Claim 1, wherein a total of the area percentage of the stabilizing Cu and the area percentage of the diffusion barrier layer is 30% to 40%.

3. The internal diffusion process $Nb_3Sn$ superconducting wire according to Claim 1 or Claim 2, wherein the area percentage of the Sn or Sn based alloy core in the cross section of the composite wire is 25% to 35%.

# FIGURE

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 63213212 A

- JP 62174354 A

**Non-patent literature cited in the description**

- *TEION KOGAKU,* 2004, vol. 39 (9), 391-398